# EUROPEAN PATENT SPECIFICATION

(11) **EP 1 599 896 B1**
(45) Date of publication and mention of the grant of the patent: **14.11.2012**
(21) Application number: 04715980.1
(22) Date of filing: 01.03.2004
(51) Int. Cl.: H01L 21/20, H01L 21/324, H01L 21/762

(54) **Preventive treatment process for the ring of a multilayer wafer**
Verfahren zur präventiven Behandlung des Ringes eines mehrschichtigen Wafers
Procédé de traitement préventif pour la couronne d'une tranche multicouche

(30) Priority: 04.03.2003 FR 0302623
(43) Date of publication of application: 30.11.2005
(73) Proprietor: Soitec, 38190 Bernin (FR)
(72) Inventor: NEYRET, Eric, F-38360 Sassenage (FR); MALLEVILLE, Christophe, F-38660 La Terrasse (FR)
(74) Representative: Collin, Jérôme
(86) International application number: PCT/IB2004/000940
(87) International publication number: WO 2004/079801

(56) References cited:
- EP-A- 1 158 581
- WO-A-03/005434
- US-A- 5 233 218
- US-A- 6 150 696
- PATENT ABSTRACTS OF JAPAN vol. 1995, no. 09, 31 October 1995 (1995-10-31) & JP 07 161948 A (CANON INC), 23 June 1995 (1995-06-23)
- PATENT ABSTRACTS OF JAPAN vol. 2000, no. 13, 5 February 2001 (2001-02-05) & JP 2000 299451 A (MATSUSHITA ELECTRIC WORKS LTD), 24 October 2000 (2000-10-24)

## Description

This invention relates to a treatment process for the ring of a multilayer wafer made by layer transfer and composed of materials chosen from among semiconductors.

Processes are known for the transfer of layers to make multilayer structures from materials chosen from among semiconducting materials.

This type of process includes the following main steps:
- creation of a weakening zone within the thickness of a donor substrate, possibly in association with the creation of different layers at the surface of the said donor substrate,
- bonding of the donor substrate with a receiving substrate,
- detachment at the weakening zone.

Following this detachment, at least one layer of the donor substrate was transferred onto the receiving substrate.

This type of process builds up wafers that may for example be of the SOI (Silicon On Insulator) type.

They can also be used to make any type of multilayer wafers.

And the wafer obtained may have one or several intermediate layers between the surface layer of the final wafer and the base layer corresponding to the receiving substrate.

Thus, an SOI has an intermediate insulating layer (for example made of SiO2) between the receiving substrate and the surface layer made of silicon.

An example of such a transfer process is the SMARTCUT^{(R)} process, and a description of this type of process is given in the "Silicon-On-Insulator Technology: Materials to VSLI, 2nd Edition" book by Jean-Pierre Colinge, published by "Kluwer Academic Publishers", p. 50 and 51.

A process of this type can be used to create multilayer wafers like those mentioned above.

It can also be used to create wafers with an extremely thin surface layer, with a thickness of the order of a few microns or less.

It will be noted that it is possible that the transfer of a layer during the detachment step is accompanied by the creation of an approximately annular peripheral shoulder around the wafer that was formed.

This type of shoulder is currently called a ring.

And it is observed that detachments made within the framework of a SMARTCUT^{(R)} type process can thus generate rings.

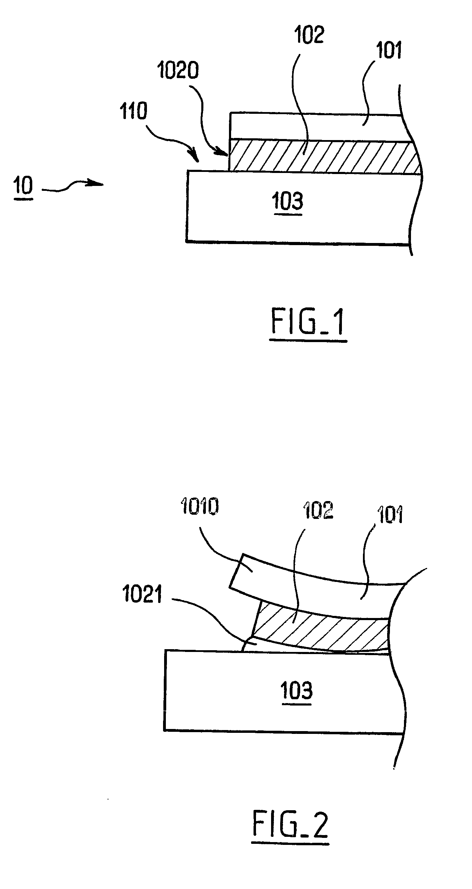

This type of ring is diagrammatically shown in Figure 1.

This figure shows the edge of an SOI type wafer 10.

The wafer 10 comprises a surface layer 101 (which usually corresponds to the so-called useful layer of the wafer) made of monocrystalline silicon that overlaps an SiO2 layer 102.

These two layers 101 and 102 are bonded to a layer 103 corresponding to the receiving substrate. For example, the layer 103 may be made of polycrystalline silicon.

The layer 102 corresponds to an intermediate layer, i.e. to a layer inserted between the surface layer 101 of the wafer and its base layer 103.

The ring 110 can be seen in this figure.

This ring extends around the entire periphery of the wafer 10. It is the result of a step for detachment of layers 101 and 102 from a weakened donor substrate.

This figure also shows that the intermediate layer 102 is exposed at its peripheral edge 1020.

As will be seen, this exposure of the peripheral belt of the intermediate layer 102 can have negative consequences.

More precisely, complementary treatments are usually applied to this type of wafer, after the detachment step that produces the results shown diagrammatically in Figure 1.

One purpose of this type of complementary treatment is to improve the surface condition of the wafer (particularly to reduce the surface roughness) or to modify the crystalline structure of one or several layers, or to reinforce the bond between the layers of the wafer.

This type of treatment may involve a chemical attack and / or heat treatment of the wafer.

For example, it may include a "stabox" step.

Note that, by convention in this text, a "stabox" step formed on a wafer corresponds to the following sequence of operations:
- oxidation of the surface of the wafer - this operation is intended to deposit an oxide layer on the surface of the wafer that will protect this surface during the next heat treatment operation,
- stabilisation heat treatment of a bonding interface - for example by annealing at a temperature of the order of 1100°C,
- deoxidation of the oxide deposited on the surface of the wafer - for example by chemical attack in an HF etching type solution with an HF solution with a concentration of 10 to 20%.

It is found that when a "stabox" type step is carried out on an SOI wafer like that shown in Figure 1, the intermediate layer 102 of the wafer is attacked around its periphery.

This effect is diagrammatically illustrated in Figure 2.

This figure shows that the layer 102 has been affected by a removal of material towards the centre of the wafer (towards the right in the case shown in Figure 2).

This removal of material is the result of the attack on the peripheral belt around the layer 102 that was exposed by the etching solution used for the deoxidation operation, as described.

Figure 2 also shows that the surface layer 101 is overhanging over this intermediate layer due to this setback of the intermediate layer, because its side edge go beyond the edge of the intermediate layer.

This overhanging configuration may be harmful.

In particular, the portion 1010 of the layer 101 that is thus overhanging may collapse and / or break.

This in itself is a disadvantage.

If a piece of this portion 1010 is detached, this piece would also form potential pollution for the wafer.

Such a detached piece could then be deposited on one of the faces of the wafer and deteriorate its surface condition (for example by scratching it or remaining stuck to it).

Wafers according to the invention are intended for use in electronics, microelectronics and optronics, and must satisfy extremely strict surface condition specifications.

Therefore it will be understood that the overhanging configuration illustrated in Figure 2 is a disadvantage.

It will also be seen that Figure 2 illustrates an additional effect of the "stabox" step.

This figure actually represents a curvature of the layers 101 and 102, the edge of these wafers being raised and separated from the base layer 103.

This curvature thus corresponds to an additional effect of the "stabox" step to which the wafer was subjected, a distinct effect of the setback of the intermediate layer and the creation of an overhang.

This additional effect is the result of thermal stresses applied to the different layers of the wafer, particularly during the oxidation heat treatment of the wafer surface.

The different layers in the wafer do not have the same coefficients of thermal expansion, and do not behave in the same way when they are exposed to a higher thermal budget.

This additional effect thus results in partial separation of layers 102 and 103 at the edge of the layer 102.

And it will also be noticed that during the same oxidation heat treatment, the space left free between the layers 102 and 103 due to this separation was partially filled in by a new oxide 1021.

However, it will be noted that this additional effect is not a major disadvantage for the problem to be solved by the invention.

The disadvantage that the invention is aimed to solve relates to shrinkage of the intermediate layer 102.

As we have seen above, this disadvantage may be the result of a chemical attack on the wafer.

It may also be the result of a different type of attack to the peripheral belt around an intermediate layer sensitive to this attack.

An attack around the exposed periphery of an intermediate layer of oxide of an SOI can thus be observed, if this wafer has been subjected to a prolonged high temperature heat treatment, for example in a furnace in which the wafers are treated in batches.

It may also be desirable to perform such a heat treatment on wafers, for example to modify the crystalline structure of some of their layers, or to reduce the surface roughness of the wafer.

This type of prolonged high temperature heat treatment is conventionally carried out under hydrogen and / or argon atmosphere.

Note that in this text, "high temperature" means a temperature exceeding the order of 950°C.

Note also that "prolonged" means a heat treatment applied for a duration of more than a few minutes.

Another example of a treatment that introduces disadvantages like those mentioned above is the case in which a "stabox" step is performed (for example on an SOI type wafer) after carrying out a first "stabox" step and polishing on the wafer.

A non-limitative example of such a treatment is divulged in document WO 01/15218.

This document describes a surface treatment of an SOI type wafer involving a sequence of stabox /polishing / stabox type steps.

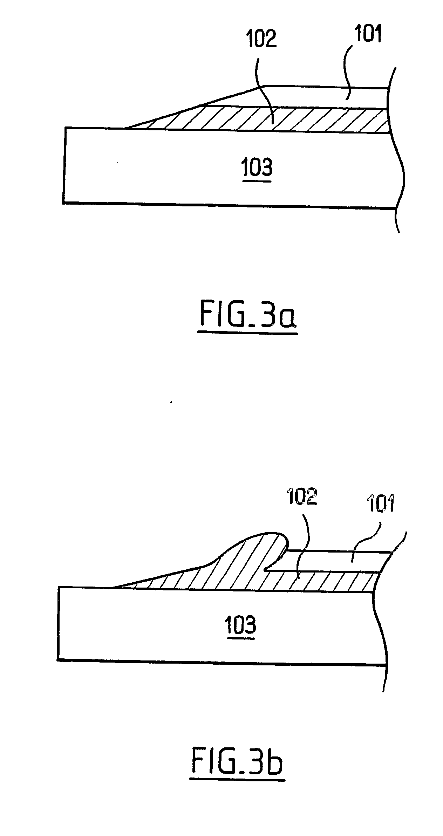

Figure 3a diagrammatically shows an SOI on which a first stabox step was carried out.

It will be seen in this figure that the edges of the layers 101 and 102 form a steep bevel following polishing.

And this bevel shape in this case further exposes the intermediate layer 102; this exposure is even greater than in the case shown in Figure 1.

Figure 3b shows the same SOI, on which a polishing step and then a second stabox step were carried out after the first stabox step.

This figure shows that the bevel shape has been modified by these new steps.

But the intermediate layer 102 is still exposed, and is therefore still subject to attack by subsequent treatments applied to the wafer.

Thus, it is clear that the treatments (particularly chemical treatments, and / or prolonged high temperature heat treatments) applied to a multilayer wafer for which an intermediate layer is exposed around its peripheral edge, may introduce disadvantages.

EP1158581 and WO 031005434 describes process for improving the roughness of a water

The purpose of the invention is to overcome said disadvantages.

To achieve this purpose, the invention proposes a process for treatment of the ring of a multilayer wafer made by layer transfer and composed of materials chosen from among semiconducting materials, said wafer comprising at least an intermediate layer between a superficial region and a base layer this treatment of the ring consisting in preventing the attack on the peripheral part of said intermediate layer of the wafer during ,a subsequent treatment step of the wafer. characterised in that the process includes rapid thermal annealing of the wafer to cause overlapping and encapsulation of the peripheral edge of said intermediate layer, by a layer of said superficial region of the surface of the wafer.

The following are preferred but non-limitative aspect of such a process:
- the rapid thermal annealing is carried out immediately after the transfer of the wafer,
- the rapid thermal annealing is carried out after an additional treatment step between the transfer of the wafer and the said rapid thermal annealing,
- the rapid thermal annealing is carried out at a temperature of the order of 1200 °C,
- the rapid thermal annealing is carried out for a duration of less than 3 minutes,
- the rapid thermal annealing is carried out under a hydrogen and / or argon atmosphere,
- the wafer is a SOI,
- the transfer was made using a SMARTCUT^{(R)} type process,
- the said subsequent treatment step of the wafer comprises a chemical attack, or a prolonged high temperature heat treatment.
- it includes a statox step and said thermal annealing is carried out after said stabox step, said stabox step being defined by the Following sequence of operations:
   - oxidation of the surface of the wafer - this operation is intended to deposit an oxide layer on the surface of the wafer that will protect this surface during the next heat treatment operation,
   - stabilisation heat treatment of a bonding interface - for example by annealing at a temperature of the order of 1100°C,
   - deoxidation of the oxide deposited on the surface of the wafer - for example by chemical attack in an HF etching type solution with an HF solution with a concentration of 10 to 20%.

Other aspects, purposes and advantages of the invention will become clearer after reading the following description with reference to the attached drawings, in which, apart from Figures 1, 2, 3a and 3b that have already been commented upon with reference to the state of the art:
- Figure 4 is a view derived from a scanning electron microscope of an edge of an SOI wafer treated according to a first embodiment of the invention, and
- Figure 5 is a similar view of the edge of an SOI wafer treated according to a second embodiment of the invention (in this case the edge represents the "right" edge, while the "left" edge of the wafer is shown in the other figures).

Note that as a preliminary to this description, wafers to which the invention is applicable may be SOI wafers.

It may also be an arbitrary type of multilayer wafer satisfying the following two conditions:
- the wafer was obtained using a transfer method (for example a SMARTCUT^{(R)} type process), and
- at least one intermediate layer of the wafer is exposed laterally and may be attacked around its periphery by a subsequent treatment (for example a chemical attack or a prolonged high temperature heat treatment), if the periphery of this intermediate layer is exposed.

Therefore, the starting point of the process according to the invention is a wafer that typically comprises a ring like that shown diagrammatically in Figure 1.

According to the invention, a rapid thermal annealing of the wafer is carried out on this type of wafer in order to overlap and then encapsulate the peripheral edge of the exposed intermediate layer, by a layer on a surface region of the wafer.

A Rapid Thermal Annealing (RTA) type heat treatment is used. For reasons of simplicity, this treatment will be referred to as RTA in the rest of this text.

The Applicant has observed that the RTA caused a very beneficial effect in the exposed intermediate layer, in terms of the problems described in the introduction of this text.

More precisely, the RTA can make the surface layer of the wafer "drop off" (in fact layer 101 in Figure 1 that corresponds to a layer of monocrystalline silicon in the case of an SOI wafer).

And this surface layer also overlaps and encapsulates the periphery of the intermediate layer (layer 102 in Figure 1) that was previously exposed.

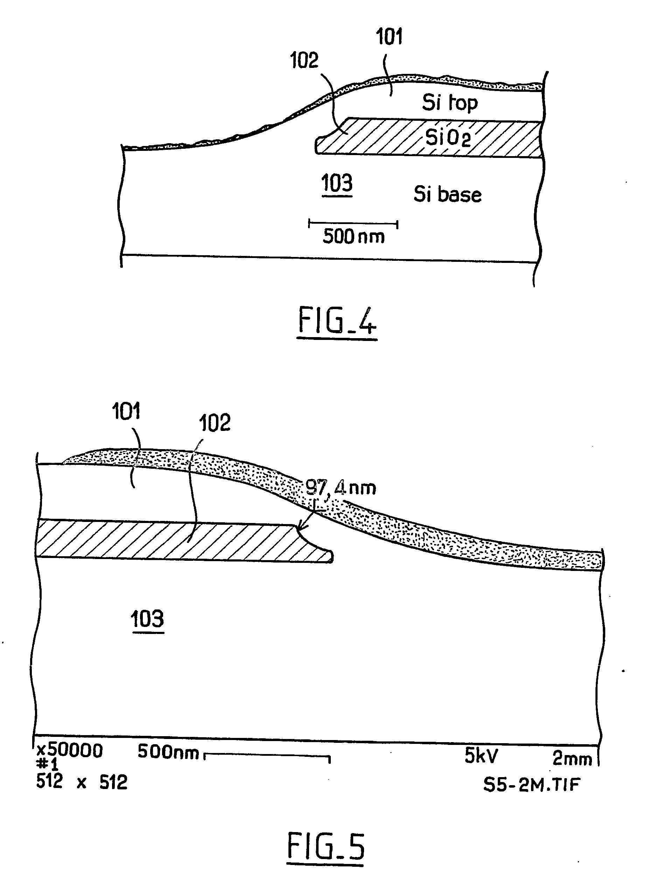

This overlapping and encapsulation effect is illustrated in Figure 4.

Figure 4 illustrates the case of an SOI wafer on which an RTA was carried out after being exposed to a stabox step.

The fact of having the RTA preceded by a stabox step stabilizes the bonding interface between the receiving substrate (layer 103) and the donor substrate (layers 101 and 102).

It can be seen in Figure 4 that the intermediate layer 102 is entirely encapsulated by the surface layer 101. The layer 102 is thus protected from subsequent heat treatments that may be applied to the wafer.

The RTA is carried out at a high temperature for a short period.

In the case of a treatment of an SOI wafer, the treatment may be carried out at a temperature of the order of 1200°C for a period of less than 3 minutes.

This RTA is carried out in a hydrogen and / or argon atmosphere.

The RTA can also be done immediately after the wafer has been detached.

In this case, the bonding interface between the layer 103 and the rest of the wafer was not stabilized by a heat treatment.

But tests carried out by the Applicant have demonstrated that this embodiment can also be used to achieve the overlapping and encapsulation effect of the intermediate layer without degrading this bonding interface.

Figure 5 is an illustration of this embodiment of the invention.

It can be seen again that the surface layer 101 overlaps and encapsulates the intermediate layer 102 that is thus protected from subsequent treatments.

And it can also be seen that the RTA has not degraded the bonding interface between layers 102 and 103.

The RTA can thus be used immediately after the wafer has been detached, or during a subsequent step.

In particular, it has been seen that the RTA can be done after a stabox step (see Figure 4).

In general, use of this RTA during a prior step is a means of securing the intermediate layer for subsequent heat treatment steps that may be applied to the wafer.

Note that wafers concerned by this invention are not limited to SOI wafers.

According to the invention, it is possible to overlap and encapsulate several intermediate layers in the wafer rather than a single layer.

In general, use of the invention causes overlapping and encapsulation of a surface region of the wafer by a layer. In particular, this layer may be the surface layer of the wafer, as shown in the examples illustrated and commented upon above.

Note that in all embodiments of the invention, the RTA protects the intermediate layer of the wafer so that it is then possible to apply treatments like those mentioned at the beginning of the text, to this wafer.

In particular, a wafer treated according to the invention can be subjected to a prolonged high temperature heat treatment, while this type of treatment would have degraded the intermediate layer if the invention is not used.

However note that in this case, a polishing step (possibly CMP) should not be done between the RTA according to the invention and the prolonged high temperature heat treatment.

This polishing step would at least partially destroy the protection applied to the intermediate layer by the invention, such that the prolonged high temperature heat treatment could degrade the intermediate layer.

## Claims

1. Process for treatment of the ring (110) of a multilayer wafer (10) made by transfer and composed of materials chosen from among semiconducting materials, said wafer comprising at least an intermediate layer (102) between a superficial region (101) and a base layer (102), this treatment of the ring (110) consisting in preventing the attack on the peripheral part of said intermediate layer (192) of the wafer (10) during a subsequent treatment step of the wafer, **characterised in that** the process includes rapid thermal annealing of the wafer (10) to clause overlapping and encapsulation of the peripheral edge of said intermediate layer (102), by a layer of said superficial region (101) of the surface of the wafer.

2. Process according to claim 1, **characterized in that** it includes a stabox step and **in that** said thermal annealing is carried out after said stabox step, said stabox step being defined by the following sequence of operations:
- oxidation of the surface of the wafer (10) - this operation is intended to deposit an oxide layer on the surface of the wafer (10) that will protect this surface during, the next heat treatm:ent operation,
- stabilisation heat treatment of a bonding interface - for example by annealing at a temperature of the order of 1100°C,
- deoxidation of the oxide deposited on the surface of the wafer (10) - for example by chemical attack in an HF etching type solution with an HF solution with a concentration of 10 to 20%.

3. Process according to claim 1, **characterised in that** the rapid thermal annealing is carried out immediately after the transfer of the wafer (10)

4. Process according to claim 1, **characterised in that** the rapid thermal annealing is carried out after an additional treatment step between the transfer of the wafer (10) and the said rapid thermal annealing.

5. Process according to one of the above claims, **characterised in that** the rapid thermal annealing is carried out at a temperature of the order of 1200°C.

6. Process according to one of the above claims, **characterised in that** the rapid thermal annealing is carried out for a duration of less than 3 minutes.

7. Process according to one of the above claims, **characterised in that** the rapid thermal annealing is carried out under a hydrogen and/or argon atmosphere.

8. Process according to one of the above claims, **characterised in that** the wafer (10) is a SOI.

9. Process according to one of the above claims, **characterised in that** the transfer was made using a SMARTCUT (R) type process.

10. Process according to one of the above claims, characterised that the said subsequent treatment step of the wafer (10) comprises a chemical attack, or a prolonged high temperature heat treatment.

## Patentansprüche

1. Prozess zum Behandeln des Rings (110) eines Mehrschichtwafers (10), der durch Schichttransfer hergestellt ist und aus Materialien gebildet ist, die unter Halbleitermaterialien ausgewählt sind, wobei der Wafer mindestens eine Zwischenschicht (102) zwischen einer Oberflächenregion (101) und einer Basisschicht (103) umfasst, wobei dieses Behandeln des Rings (110) darin besteht, das Angreifen des peripheren Teils der Zwischenschicht (102) des Wafers (10) während eines anschließenden Behandlungsschrittes des Wafers zu verhindern, **dadurch gekennzeichnet, dass** der Prozess ein schnelles thermisches Glühen des Wafers (10) umfasst, um ein Überlappen und Verkapseln des peripheren Randes der Zwischenschicht (102) durch eine Schicht der Oberflächenregion (101) der Oberfläche des Wafers zu bewirken.

2. Prozess nach Anspruch 1, **dadurch gekennzeichnet, dass** er einen Stabox-Schritt umfasst und dass das thermische Glühen nach dem Stabox-Schritt durchgeführt wird, wobei der Stabox-Schritt durch die folgende Sequenz von Arbeitsschritten definiert ist:
- Oxidieren der Oberfläche des Wafers (10) - dieser Arbeitsschritt dient dazu, eine Oxidschicht auf der Oberfläche des Wafers (10) abzuscheiden, die diese Oberfläche während des nächsten Wärmebehandlungsschrittes schützt,
- stabilisierende Wärmebehandlung einer Bondungsgrenzfläche - zum Beispiel durch Glühen bei einer Temperatur in der Größenordnung von 1.100°C,
- Entoxidieren des auf der Oberfläche des Wafers (10) abgeschiedenen Oxids - zum Beispiel durch chemischen Angriff in einer HF-Ätzlösung mit einer HF-Lösung mit einer Konzentration von 10 bis 20 %.

3. Prozess nach Anspruch 1, **dadurch gekennzeichnet, dass** das schnelle thermische Glühen unmittelbar nach dem Transfer des Wafers (10) durchgeführt wird.

4. Prozess nach Anspruch 1, **dadurch gekennzeichnet, dass** das schnelle thermische Glühen nach einem zusätzlichen Behandlungsschritt zwischen dem Transfer des Wafers (10) und dem schnellen thermischen Glühen durchgeführt wird.

5. Prozess nach einem der vorangehenden Ansprüche, **dadurch gekennzeichnet, dass** das schnelle thermische Glühen bei einer Temperatur in der Größenordnung von 1200 °C durchgeführt wird.

6. Prozess nach einem der vorangehenden Ansprüche, **dadurch gekennzeichnet, dass** das schnelle thermische Glühen über eine Dauer von weniger als 3 Minuten durchgeführt wird.

7. Prozess nach einem der vorangehenden Ansprüche, **dadurch gekennzeichnet, dass** das schnelle thermische Glühen unter einer Wasserstoff- und/oder Argonatmosphäre durchgeführt wird.

8. Prozess nach einem der vorangehenden Ansprüche, **dadurch gekennzeichnet, dass** der Wafer (10) ein SOI ist.

9. Prozess nach einem der vorangehenden Ansprüche, **dadurch gekennzeichnet, dass** der Transfer mittels eines SMARTCUT(R)-Prozesses durchgeführt wurde.

10. Prozess nach einem der vorangehenden Ansprüche, **dadurch gekennzeichnet, dass** der anschließende Behandlungsschritt des Wafers (10) einen chemischen Angriff oder eine längere Hochtemperatur-Wärmebehandlung umfasst.

## Revendications

1. Procédé de traitement de la couronne (110) d'une tranche multicouche (10) constituée par transfert de couche et composée de matériaux choisis parmi des matériaux semi-conducteurs, ladite tranche comprenant au moins une couche intermédiaire (102) entre une région superficielle (101) et une couche de base (103), ce traitement de la couronne (110) consistant à empêcher l'attaque de la partie périphérique de ladite couche intermédiaire (102) de la tranche (10) au cours d'une étape de traitement ultérieur de la tranche, **caractérisé en ce que** le procédé comprend le recuit thermique rapide de la tranche (10) pour provoquer le chevauchement et l'encapsulation du bord périphérique de ladite couche intermédiaire (102), par une couche de ladite région superficielle (101) de la surface de la tranche.

2. Procédé selon la revendication 1, caractérisé i en ce qu'il comprend une étape stabox et en ce que ledit recuit thermique est effectué après ladite étape stabox, ladite étape stabox étant définie par la séquence suivante d'opérations :
- l'oxydation de la surface de la tranche (10), cette opération étant destinée à déposer une couche d'oxyde sur la surface de la tranche (10) qui protégera cette surface au cours de l'opération de traitement thermique suivante,
- le traitement thermique de stabilisation d'une interface de liaison, par exemple par recuit à une température de l'ordre de 1100° C,
- la désoxydation de l'oxyde déposé sur la surface de la tranche (10), par exemple par attaque chimique dans une solution de type gravure HF avec une solution HF à une concentration de 10 à 20 %.

3. Procédé selon la revendication 1, **caractérisé en ce que** le recuit thermique rapide est effectué immédiatement après le transfert de la tranche (10).

4. Procédé selon la revendication 1, **caractérisé en ce que** le recuit thermique rapide est effectué après une étape de traitement supplémentaire entre le transfert de la tranche (10) et ledit recuit thermique rapide.

5. Procédé selon l'une des revendications précédentes, **caractérisé en ce que** le recuit thermique rapide est effectué à une température de l'ordre de 1200° C.

6. Procédé selon l'une des revendications précédentes, **caractérisé en ce que** le recuit thermique rapide est effectué pendant une durée de moins de 3 minuties.

7. Procédé selon l'une des revendications précédentes, **caractérisé en ce que** le recuit thermique rapide est effectué sous une atmosphère d'hydrogène et/ou d'argon.

8. Procédé selon l'une des revendications précédentes, **caractérisé en ce que** la tranche (10) est un silicium sur isolant SOI.

9. Procédé selon l'une des revendications précédentes, **caractérisé en ce que** la tranche est constituée en utilisant un procédé de type SMARTCUT^{®}.

10. Procédé selon l'une des revendications précédentes, **caractérisé en ce que** ladite étape de traitement ultérieur de la tranche (10) comprend une attaque chimique ou un traitement thermique à haute température prolongé.
